# FASCICULE DE BREVET EUROPEEN

(11) **EP 1 764 887 B1**
(45) Date de publication et mention de la délivrance du brevet: **27.08.2008**
(21) Numéro de dépôt: 06116861.3
(22) Date de dépôt: 07.07.2006
(51) Int. Cl.: H01S 5/026, H01S 5/22

(54) **Dispositif opto-electronique comportant un laser et un modulateur integres et procede de realisation associe**
Optoelektronische Vorrichtung mit einem Laser mit integriertem Modulator und Herstellungsverfahren dafür
Opto-electronic device comprising a laser integrated with a modulator and method of fabrication thereof

(30) Priorité: 08.07.2005 FR 0507322
(43) Date de publication de la demande: 21.03.2007
(73) Titulaire: Alcatel Lucent, 75008 Paris (FR)
(72) Inventeur: Le Pallec, Michel, 91300 Massy (FR); Kazmierski, Christophe, 91420 Morangis (FR)
(74) Mandataire: Shamsaei Far, Hassan

(56) Documents cités:
- EP-A- 1 233 486
- EP-A- 1 372 229
- US-A- 5 901 265
- AOKI M ET AL: "HIGH-SPEED (10GBIT/S) AND LOW-DRIVE-VOLTAGE (1V PEAK TO PEAK) INGAAS/INGAASP MQW ELECTROABSORPTION-MODULATOR INTEGRATED DFB LASER WITH SEMI-INSULATING BURIED HETEROSTRUCTURE" ELECTRONICS LETTERS, IEE STEVENAGE, GB, vol. 28, no. 12, 4 juin 1992 (1992-06-04), pages 1157-1158, XP000304649 ISSN: 0013-5194

## Description

Le domaine de l'invention est celui des dispositifs d'émission optique comprenant un composant intégré comportant au moins une section laser d'émission et une section de modulation de la puissance optique émise par le laser. On appelle encore ces systèmes ILM, acronyme anglo-saxon de Integrated Laser Modulator ou EML, acronyme anglo-saxon de Electro-absorption Modulated Laser. La section de modulation est généralement appelée également EAM, acronyme anglo-saxon de Electro Absorption Modulator.

Ces dispositifs sont utilisés principalement dans le domaine des télécommunications numériques haut débit. Les débits sont typiquement de quelques gigabits à plusieurs dizaines de gigabits par seconde.

Il est possible de moduler un faisceau laser de trois façons différentes. Une première méthode consiste à moduler directement le laser source en pilotant son courant d'alimentation. Cependant, cette technique ne permet pas d'atteindre les performances nécessaires au haut débit. Il est également possible d'utiliser un modulateur externe, physiquement séparé du laser source et dont les performances ne sont pas limitées par celles du laser. Cependant, cette méthode pose des problèmes d'intégration et de positionnement importants. Enfin, il est possible de réaliser un composant intégré comportant, sur le même substrat, une section laser d'émission et une section de modulation de la puissance optique émise par le laser. On obtient ainsi le meilleur compromis entre les performances souhaitées et les problèmes technologiques de réalisation et d'intégration.

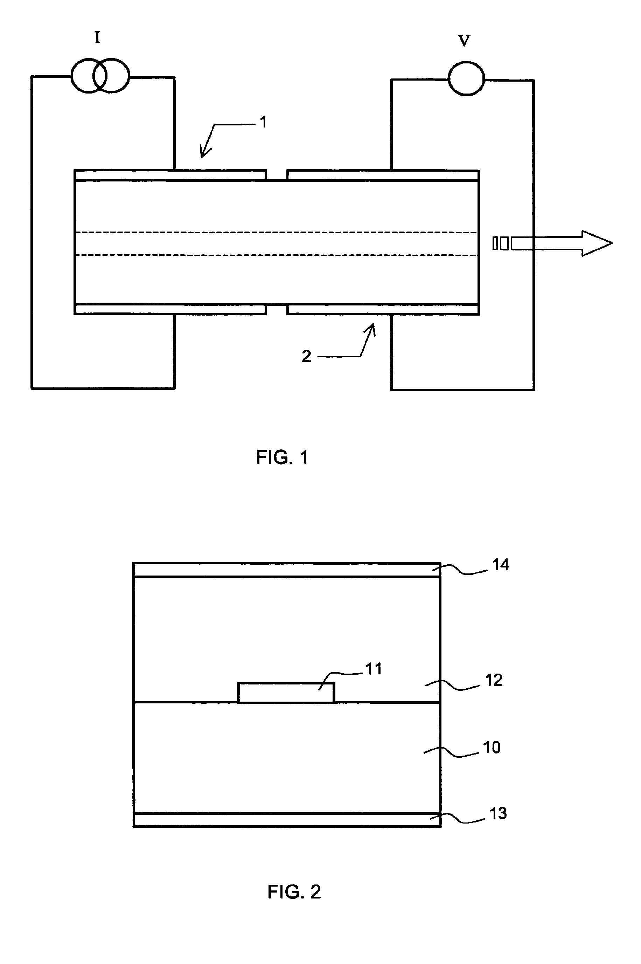

Ce dernier type de dispositif dit ILM est connu et est décrit, par exemple, dans le brevet français FR2 675 634. A titre d'exemple, un dispositif ILM est représenté schématiquement sur la figure 1. Il comprend essentiellement une section laser 1 et une section de modulation 2. Comme indiqué sur la figure 1, le laser est piloté par un courant I et la section de modulation 2 est une section électro-absorbante, commandée en tout ou rien par un signal de tension V. A la sortie du dispositif ILM, un signal optique modulé à haute fréquence est émis (flèche droite rayée de la figure 1).

Généralement, la structure d'émission optique est un laser semi-conducteur à ruban enterré encore appelée structure BRS, acronyme anglo-saxon de Buried Ridge Stripe. Un schéma d'une telle structure est représenté en figure 2. Il comprend essentiellement :
- Un premier substrat 10 en matériau semi-conducteur dopé n. Le premier substrat est généralement en phosphure d'indium (InP) ;
- Une partie active 11 formée par un ruban de section droite rectangulaire, la face inférieure de cette partie active reposant sur le premier substrat 10. La partie active a un indice optique supérieure à celui des couches qui l'entourent. Elle est de faible section, de l'ordre du micron
ou de quelques microns, et est généralement constituée d'un ensemble de couches formant des puits et des barrières quantiques. Les couches sont classiquement en GaInAsP ou en AIGaInAs ;
- Un second substrat 12 en matériau semi-conducteur dopé p. Ce second substrat est également en InP et il recouvre complètement les faces latérales et la face supérieure de la partie active 10 ;
- Une électrode inférieure 13 disposée sous le premier substrat 10 et une électrode supérieure 14 disposée sur le second substrat 12. Les électrodes amènent le courant nécessaire au fonctionnement du laser.

Cette configuration permet d'assurer, à la fois :
- Un confinement des porteurs injectés dans le ruban si la différence de largeur de bande interdite entre le matériau du premier substrat et celui du second substrat est suffisante ;
- Un guidage bidirectionnelle de la lumière si la différence d'indice optique entre le matériau du premier substrat et celui du second substrat est également suffisante.

L'intérêt de cette configuration géométrique est d'obtenir des lasers à très faible courant de seuil et à très grande vitesse de commutation.

Depuis l'apparition de ce type de structure dans les années 1980, des développements technologiques ont permis d'améliorer les performances de ce type de laser. On utilise généralement des structures comportant des couches semi-isolantes. On trouvera des descriptions de ce type de structure dans le brevet français FR 91 04636. Un schéma d'une telle structure est représenté en figure 3. Il comprend essentiellement :
- Un premier substrat 10 en matériau semi-conducteur dopé n, généralement en InP ;
- Une partie active 11 formée par un ruban de section droite rectangulaire, la face inférieure de cette partie active reposant sur le premier substrat 10 ;
- une couche de confinement latéral 15 entourant les faces latérales du ruban. Cette couche 15 est en matériau semi-conducteur semi-isolant, généralement en InP dopé Fe ;
- une couche de confinement vertical 16, recouvrant la face supérieure de la partie active 10, ladite couche 16 en matériau semi-conducteur dopé p. Le dopant est généralement le zinc.
- Une électrode inférieure 13 disposée sous le premier substrat et une électrode supérieure 14 disposée sur la couche de confinement vertical 16 et sur la couche de confinement latéral 15. Ces électrodes amènent le courant nécessaire au fonctionnement du laser.
   Ce type de laser est encore appelé SI BH, acronyme de Semi-Insulating Burried Heterostructure.

Bien entendu, dans les dispositifs ILM, la section laser et la section modulateur ont la même structure enterrée. On obtient ainsi des dispositifs ayant de très bonnes performances en terme de dissipation thermique, de pertes optiques, de stabilité des modes optiques et de fiabilité. De plus, l'intégration des deux fonctions d'émission et de modulation dans un composant unique permet de réduire les coûts de façon substantielle.

Cependant, un laser de type SI BH présente un courant de fuite latéral important dû à une décroissance rapide de la résistivité de la couche de confinement latéral lorsque l'on applique une tension positive sur la structure. Cet effet est largement connu et décrit. Il résulte de l'interdiffusion des dopants p de la couche de confinement vertical et des dopants de la couche de confinement latéral semi-isolante pendant l'étape de réalisation de la couche de confinement vertical. Ce courant de fuite dégrade de façon sensible les performances du laser.

Il existe différentes techniques pour tenter de réduire ce problème. On citera :
- La réduction de la surface de la structure active pendant l'étape de gravure latérale de la structure ou l'augmentation de l'épaisseur de la couche de confinement vertical afin de conserver une surface suffisamment résistive. Ces solutions ne permettent pas, cependant, de supprimer complètement le courant de fuite ;
- L'utilisation de couches de blocage, empêchant la diffusion des dopants p. Malheureusement, dans le cas d'un dispositif ILM, cette technologie accroît la capacité parasite de la section de modulation qui devient trop importante pour une utilisation à haut débit ;
- L'utilisation d'autres types de dopants comme le Ruthénium qui présentent les inconvénients d'être difficiles à mettre en oeuvre dans les équipements de croissance épitaxiale et dont l'efficacité n'a pas été prouvée dans les conditions d'utilisation du laser.
- L'utilisation d'autres types de structures comme les structures de type PN-BH, acronyme anglo-saxon signifiant P-type N-type Buried Heterostructure, comportant une couche de confinement vertical tronquée. Cependant, ces structures qui ont de bonnes performances font appel à un processus de fabrication complexe comportant des étapes supplémentaires de croissance épitaxiale et de tronçonnement de la couche de confinement vertical, difficiles à maîtriser parfaitement. Cette technologie conduit également à des structures dont la capacité parasite trop importante n'autorise pas une utilisation haut débit.

L'objet de l'invention est de proposer un composant intégré de type ILM comprenant au moins une section laser d'émission et une section de modulation comportant une structure de type SI BH technologiquement bien maîtrisée et ne présentant ni courant de fuite ni capacité parasite importants. Ainsi, un dispositif selon l'invention permet d'atteindre des performances importantes, compatibles des télécommunications numériques haut débit tout en ne présentant pas de difficultés de réalisation particulière.

Plus précisément, l'invention a pour objet un dispositif opto-électronique, de type à laser et modulateur intégré comportant une section laser et une section de modulation réalisées dans une structure commune de type P.I.N, ladite structure comprenant successivement un substrat en matériau semi-conducteur dopé n, une zone active enterrée, une couche de confinement vertical dopé p, les faces latérales de la zone active étant entourées par une couche de confinement latéral semi-isolante en matériau semi-conducteur dopé, caractérisé en ce que la partie de la structure appartenant à la section laser comporte une couche bloquante en matériau semi-conducteur dopé n disposée entre la couche de confinement latéral semi-isolante et la couche de confinement vertical.

Avantageusement, le substrat, la couche de confinement vertical, la couche de confinement latéral et la couche bloquante sont essentiellement réalisés dans un premier matériau semi-conducteur dont les composants appartiennent aux groupes III et V de la classification périodique.

Plus précisément, la couche bloquante peut être réalisée en InP (Phosphure d'Indium), en InGaAsP (Indium-Gallium-Arsenio-Phosphore) ou en InAlAs (Indium-Aluminium-Arsenic), la zone active étant réalisée en InGaAsP (Indium-Gallium-Arsenic-Phosphore).

Avantageusement, les dopages du substrat et de la couche de confinement vertical sont de l'ordre de 10¹⁸ atomes/centimètres³, le dopage de la couche de confinement latéral est de 10¹⁷ atomes/centimètres³ et le dopage de la couche bloquante est de l'ordre de 10¹⁸ atomes/centimètres³.

Avantageusement, la largeur de la zone active vaut environ 1,5 micron et l'épaisseur de la structure commune vaut quelques microns, l'épaisseur de la couche bloquante est, quand à elle, inférieure au micron.

Avantageusement, la structure comporte une couche écran ou couche tampon dite couche « buffer » en terminologie anglo-saxonne disposée entre le substrat et la couche active, ladite couche étant également réalisée en Phosphure d'Indium (InP).

L'invention concerne également un procédé de réalisation d'un dispositif opto-électronique, de type à laser et modulateur intégré comportant au moins l'une des caractéristiques précédentes. Ledit procédé comporte au moins les étapes suivantes :
- Etape 1 : Réalisation sur le substrat de la zone active au moyen d'une première croissance épitaxiale et gravure de ladite zone ;
- Etape 2 : Réalisation de la couche de confinement latéral semi-isolante au moyen d'une seconde croissance épitaxiale ;
- Etape 5 : Réalisation de la couche de confinement vertical dopée P au moyen d'une troisième croissance épitaxiale ;
caractérisé en ce que le procédé de réalisation comporte, en outre, les deux étapes supplémentaires suivantes réalisées successivement entre la seconde étape et la cinquième étape qui sont :
- Etape 3 : réalisation de la couche bloquante sur l'intégralité de la couche de confinement latéral semi-isolante ;
- Etape 4 : suppression de la couche bloquante dans la zone de la structure correspondant à la section de modulation.
   Avantageusement, l'étape 4 du procédé est réalisé par gravure chimique ou mécanique.

L'invention sera mieux comprise et d'autres avantages apparaîtront à la lecture de la description qui va suivre donnée à titre non limitatif et grâce aux figures annexées parmi lesquelles :
- La figure 1 représente le schéma de principe d'un dispositif opto-électronique de type ILM ;
- La figure 2 représente une vue en coupe d'un laser à ruban enterré de type BRS ;
- La figure 3 représente une vue en coupe d'un laser à ruban enterré de type BRS à couche semi-isolante ;
- La figure 4 représente une première vue en coupe d'un dispositif ILM selon l'invention ;
- La figure 5 représente une seconde vue en coupe dans la section laser d'un dispositif ILM selon l'invention ;
- La figure 6 représente une troisième vue en coupe dans la section modulateur d'un dispositif ILM selon l'invention.

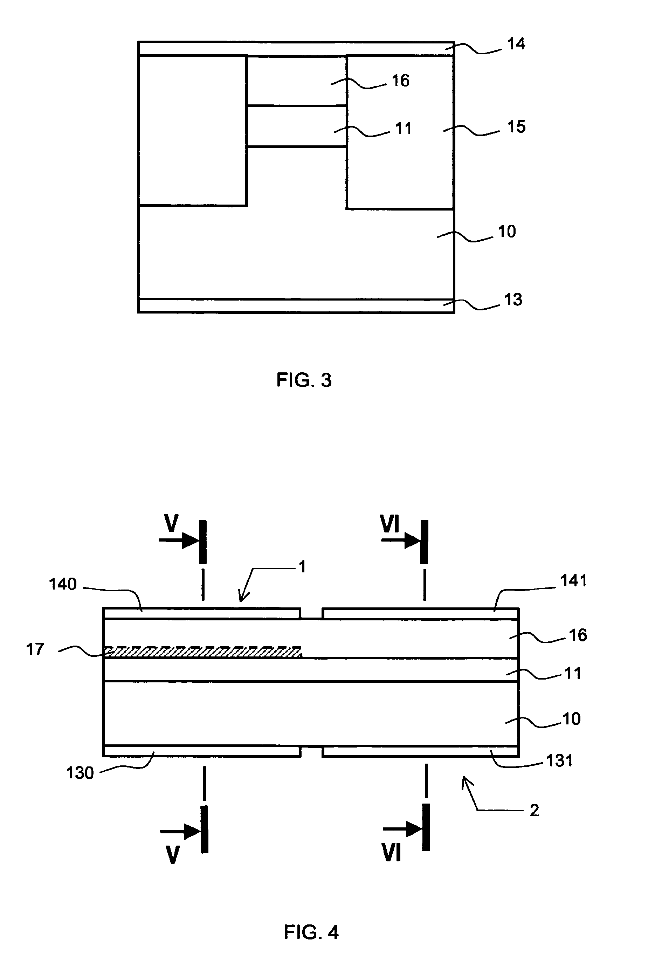

La vue en coupe de la figure 4 représente un dispositif de type ILM selon l'invention comprenant une section laser et une section de modulation. Il comprend essentiellement une structure commune de type P.I.N, ladite structure comprenant successivement :
- un substrat 10 en matériau semi-conducteur dopé n,
- une zone active enterrée 11 formée par un ruban de section droite rectangulaire,
- une couche de confinement vertical 16 dopé p, les faces latérales de la zone active étant entourées par une couche de confinement latéral semi-isolante en matériau semi-conducteur dopé, non représentée sur la figure.

La section laser comporte une couche bloquante 17 en matériau semi-conducteur dopé n disposée entre la couche de confinement latéral semi-isolante et la couche de confinement vertical.

Le substrat, la couche de confinement vertical, la couche de confinement latéral et la couche bloquante sont essentiellement réalisées dans un premier matériau semi-conducteur dont les composants appartiennent aux groupes III et V de la classification périodique. A titre d'exemple, ledit premier matériau est du Phosphure d'Indium (InP). les dopages du substrat et de la couche de confinement vertical sont de l'ordre de 10¹⁸ atomes/centimètres³ et le dopage de la couche de confinement latéral est de 10¹⁷ atomes/centimètres³.

La structure est organisée en deux sections 1 et 2 pilotées par deux jeux d'électrodes indépendantes 130, 140 et 131, 141 disposées respectivement sur la face inférieure du substrat 10 et la face supérieure de la couche de confinement vertical 16. Les électrodes 130 et 131 peuvent être reliées entre elles par une terre commune. A titre d'exemple, ces électrodes comprennent un première couche conductrice qui peut être en InGaAs dopé p. L'épaisseur de cette couche est inférieure au micron et son dopage est de l'ordre de 10¹⁹ atomes/centimètres³. Sur cette première couche, on dépose le contact électrique métallique proprement dit.

La section 1 correspond à la section laser et la section 2 correspond à la section de modulation. La section laser 1 comporte une couche bloquante 17 en matériau semi-conducteur dopé n disposée entre la couche de confinement latéral semi-isolante et la couche de confinement vertical 16.

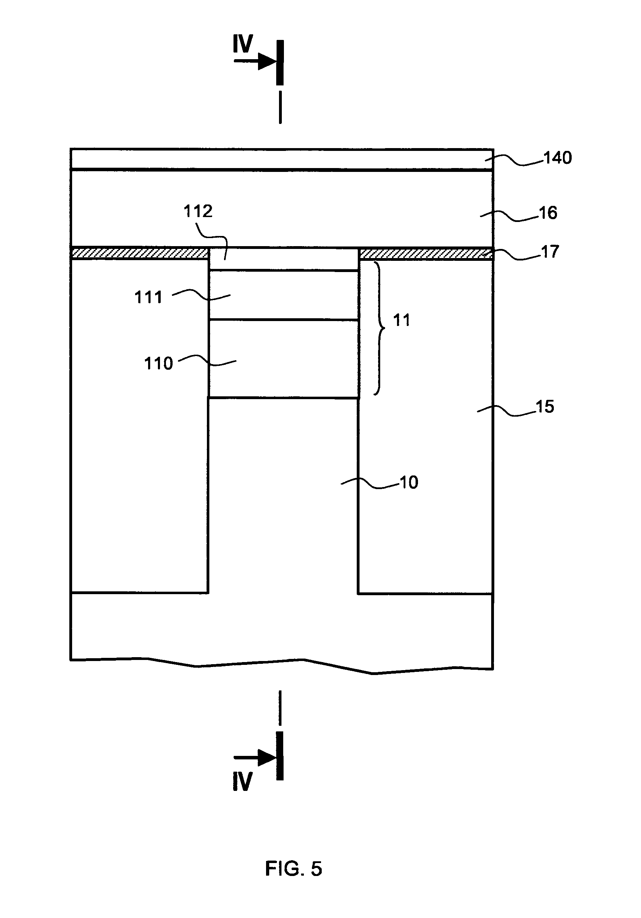

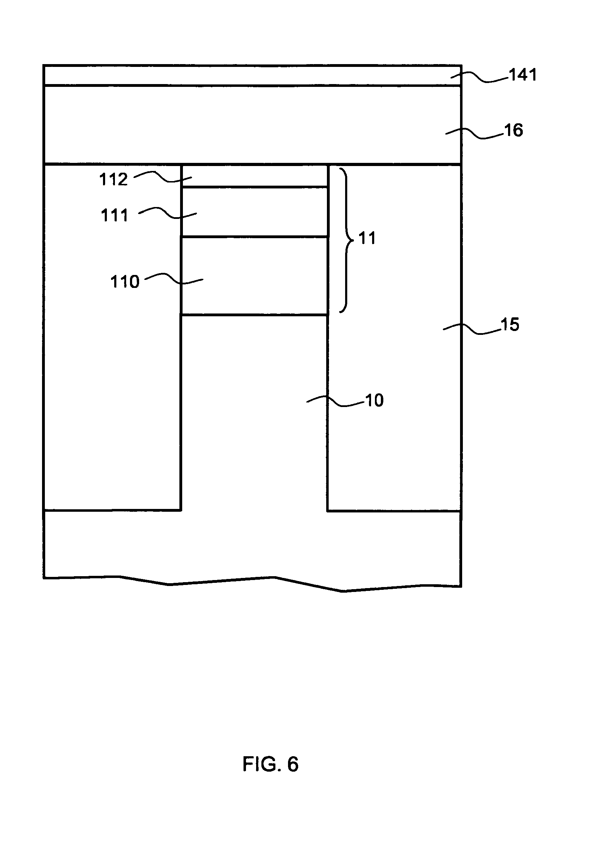

Les figures 5 et 6 représentent deux vues en coupe du dispositif de la figure 4 dans deux plans perpendiculaires à celui de la figure 4. Ces vues permettent de mieux préciser l'agencement interne des différentes couches de la structure. Sur ces vues en coupe, la partie basse de la structure comportant les électrodes 130 et 131 n'est pas représentée.

Sur les figures 5 et 6, la zone active 111 est enterrée au sein de la structure. Sa face inférieure est en contact avec le substrat 10. Ses faces latérales sont en contact avec la couche de confinement latéral semi-isolante 15, sa face supérieure est en contact avec la couche de confinement vertical 16. L'épaisseur totale de la structure commune vaut quelques microns.

La largeur de la zone active vaut environ 1,5 micron et son épaisseur est inférieure au micron.

La zone active comporte nécessairement une couche 111 de matériau actif qui peut être, par exemple, InGaAsP (Indium-Gallium-Arsenic-Phosphore) ou être une combinaison de la famille de matériaux AlInGaAsP. (Aluminium-Indium-Gallium-Arsenic-Phosphore). La composition du matériau actif détermine la longueur d'onde d'émission du laser, généralement située dans le proche infra-rouge pour des applications en télécommunications. Elle peut cependant comporter d'autres couches comme une couche « buffer » 110 ou une couche de protection 112, la couche « buffer » 110, en raison de son mode de croissance possède une qualité cristalline supérieure, elle est également réalisée en Phosphore d'Indium (InP).

Comme indiqué sur la figure 5, la couche bloquante de la section laser est disposée de part et d'autre de la face supérieure de la zone active, entre la couche de confinement latéral semi-isolante 15 et la couche de confinement vertical 16.

La couche bloquante est réalisée en matériau semi-conducteur dopé n qui peut être, par exemple, du phosphure d'Indium (InP) ou de l'InGaAsP (Indium-Gallium-Arsenic-Phosphore) ou de l'InAlAs (Indium-Aluminium-Arsenic) ou une combinaison de la famille des matériaux AlInGaAsP (Aluminium-Indium-Gallium-Arsenic-Phosphore). Le dopage de la couche bloquante est de l'ordre de 10¹⁸ atomes/centimètres³.

Son épaisseur est typiquement de quelques dixièmes de micron.

La couche bloquante limite l'interdiffusion des dopants entre les couches de confinement vertical et latéral 15 et 16. Elle permet de préserver le caractère semi-isolant de la couche de confinement latéral sans introduire de capacités parasites ou de résistances supplémentaires.

Comme indiqué sur la figure 6, la couche bloquante est limitée à la section laser, la section de modulation ne comportant pas de couche bloquante. Une isolation ionique assure la frontière entre la section laser et la section de modulation. On élimine ainsi toute capacité parasite dans la section de modulation.

La réalisation d'un dispositif selon l'invention ne présente pas de difficulté particulière.

Il comporte essentiellement les étapes suivantes :
- Etape 1 : Réalisation sur le substrat de la zone active au moyen d'une première croissance épitaxiale puis gravure de façon à laisser subsister un mésa central comportant la zone active finale ;
- Etape 2 : Réalisation de la couche de confinement latéral semi-isolante au moyen d'une seconde croissance épitaxiale ;
- Etape 3 : Réalisation de la couche bloquante sur l'intégralité de la couche de confinement latéral semi-isolante ;
- Etape 4 : Suppression de la couche bloquante dans la zone de la structure correspondant à la section de modulation. Cette suppression peut être réalisée soit par attaque chimique, soit par gravure mécanique ou sèche. La précision requise est de l'ordre de quelques centaines de nanomètres.
- Etape 5 : Réalisation de la couche de confinement vertical semi-isolante au moyen d'une troisième croissance épitaxiale ;
- Etape 6 : Réalisation des électrodes de contact.

La réalisation des couches par croissance épitaxiale et leur délimitation par gravure chimique ou mécanique fait partie des connaissances de l'homme du métier. On trouvera des exemples de ce type de procédés dans les brevets français FR 2 675 634 et FR 2 820 891.

## Revendications

1. Dispositif opto-électronique, de type à laser et modulateur intégré comportant une section laser (1) et une section de modulation (2) réalisées dans une structure commune de type P.I.N, ladite structure comprenant successivement un substrat (10) en matériau semi-conducteur dopé n, une zone active enterrée (11), une couche de confinement vertical (16) dopé p, les faces latérales de la zone active étant entourées par une couche de confinement latéral (15) semi-isolante en matériau semi-conducteur dopé, **caractérisé en ce que** la partie de la structure appartenant à la section laser comporte une couche bloquante (17) limitée à la section laser en matériau semi-conducteur dopé n disposée entre la couche de confinement latéral (15) semi-isolante et la couche de confinement vertical (16).

2. Dispositif opto-électronique selon la revendication 1, **caractérisé en ce que** le substrat (10), la couche de confinement vertical (16), la couche de confinement latéral (15) et la couche bloquante (17) sont essentiellement réalisés dans un premier matériau semi-conducteur dont les composants appartiennent aux groupes III et V de la classification périodique.

3. Dispositif opto-électronique selon la revendication 1, **caractérisé en ce que** la couche bloquante (17) est réalisée en Phosphure d'Indium (InP).ou en InGaAsP (Indium-Gallium-Arsenic-Phosphore) ou en InAlAs (Indium-Aluminium-Arsenic) ou en une combinaison de la famille de matériaux AllnGaAsP.

4. Dispositif opto-électronique selon la revendication 1, **caractérisé en ce que** la zone active (11) est réalisée en InGaAsP (Indium-Gallium-Arsenic-Phosphore) ou en une combinaison de la famille de matériaux AllnGaAsP.

5. Dispositif opto-électronique selon la revendication 1, **caractérisé en ce que** la largeur de la zone active (11) vaut environ 1,5 micron et l'épaisseur de la structure commune vaut quelques microns.

6. Dispositif opto-électronique selon la revendication 1, **caractérisé en ce que** l'épaisseur de la couche bloquante est inférieure au micron.

7. Dispositif opto-électronique selon la revendication 1, **caractérisé en ce que** la structure comporte une couche écran disposée entre le substrat et la couche active, ladite couche étant également réalisée en Phosphore d'Indium (InP).

8. Procédé de réalisation d'un dispositif opto-électronique, de type à laser et modulateur intégré selon l'une des revendications précédentes et comportant au moins les étapes suivantes :
• Etape 1 : Réalisation sur le substrat (10) de la zone active (11) au moyen d'une première croissance épitaxiale et gravure ;
• Etape 2 : Réalisation de la couche de confinement latéral (15) semi-isolante au moyen d'une seconde croissance épitaxiale ;
• Etape 5 : Réalisation de la couche de confinement vertical (16) semi-isolante au moyen d'une troisième croissance épitaxiale ;
**caractérisé en ce que** le procédé de réalisation comporte, en outre, les deux étapes supplémentaires suivantes réalisées entre la seconde étape et la cinquième étape qui sont :
• Etape 3 : réalisation de la couche bloquante (17) sur l'intégralité de la couche de confinement latéral semi-isolante (15) ;
• Etape 4 : suppression de la couche bloquante dans la zone de la structure correspondant à la section de modulation (2).

9. Procédé de réalisation selon la revendication 8, **caractérisé en ce que** l'étape 4 du procédé est réalisé par gravure chimique ou mécanique.

## Claims

1. An opto-electronic device, with a laser and integrated modulator, which incudes a laser section (1) and a modulation section (2) produced in a shared PIN structure, said structuring comprising in order a substrate (10) produced from n-doped semi-conductor material, a buried active zone (11), and a p-doped vertical confinement layer (16), the lateral faces of the active zone being surrounded by a semi-insulatirig lateral confinement layer (15) produced from doped semi-conductor material, wherein the part of the structure belonging to the laser section includes a blocking layer (17) limited to the laser section produced from n-doped semi-conductor material placed between the semi-insulating lateral confinement layer (15) and the vertical confinement layer (16).

2. An opto-electronic device according to claim 1, wherein the substrate (10), the vertical confinement layer (16), the lateral confinement layer (15) and the blocking layer (17) are essentially produced from a first semi-conductor material whose components belong to groups III and IV of the periodic table.

3. An opto-electronic device according to claim 1, wherein the blocking layer (17) is produced from indium Phosphide (InP) or from InGaAsP (Indium-Gallium-Arsenic-Phosphorus) or from InAlAs (Indium-Aluminum-Arsenic) or from a combination of the family of AllnGaAsP materials.

4. An opto-electronic device according to clam 1, wherein the active zone (11) is produced from InGaAsP (Indium-Gallium-Arsenic-Phosphorus) or from a combination of the family of AllnGaAsP materials.

5. An opto-electronic device according to claim 1, wherein the width of the active zone (11) is about 1.5 microns and the thickness of the shared structure is a few microns.

6. An opto-electronic device according to claim 1, wherein the thickness of the blocking layer is less than a micron.

7. An opto-electronic device according to claim 1, wherein the structure comprises a screen layer placed between the substrate and the active layer, said layer also being produced from Indium Phosphorus (InP).

8. A method of producing an opto-electronic device with a laser and integrated modulator according to claim 1, comprising at least the following steps:
• Step 1: Production on the substrate (10) of the active zone (11) by means of a first epitaxial growth and etching;
• Step 2: Production of the semi-insulating lateral confinement layer (15) by means of a second epitaxial growth;
• Step 5: Production of the semi-insulating vertical confinement layer (16) by means of a third epitaxial growth,
**Characterized in that** the production method further includes the two following additional steps, carried out between the second step and the fifth step, which are:
• Step 3: Production of the blocking layer (17) over the entirety of the semi-insulating lateral confinement layer (15);
• Step 4: Removal of the blocking layer in the zone of the structure corresponding to the modulation section (2);

9. A method of production according to claim 8, wherein step 4 of the method is carried out by chemical or mechanical etching.

## Patentansprüche

1. Optoelektronische Vorrichtung vom Typ Laser mit integriertem Modulator, die einen Laserabschnitt (1) und einen Modulationsabschnitt (2) umfasst, die in einer gemeinsamen Struktur vom Typ P.I.N, ausgeführt sind, wobei die genannte Struktur aufeinander folgend ein Substrat (10) aus einem n-dotierten Halbleitermaterial, eine eingebettete aktive Zone (11), eine p-dotierte vertikale Einschlussschicht (16) umfasst, wobei die Seitenflächen der aktiven Zone von einer semi-isolierenden seitlichen Einschlussschicht (15) aus einem dotierten Halbleitermaterial umgeben sind, **dadurch gekennzeichnet, dass** der Teil der Struktur, der zum Laserabschnitt gehört, eine auf den Laserabschnitt begrenzte Sperrschicht (17) aus einem n-dotierten Halbleitermaterial umfasst, die zwischen der semi-isolierenden seitlichen Einschlussschicht (15) und der vertikalen Einschlussschicht (16) angeordnet ist.

2. Optoelektronische Vorrichtung gemäß Anspruch 1, **dadurch gekennzeichnet, dass** das Substrat (10), die vertikale Einschlussschicht (16), die seitliche Einschlussschicht (15) und die Sperrschicht (17) im Wesentlichen aus einem ersten Halbleitermaterial ausgeführt sind, dessen Bestandteile zu den Gruppen III und V des Periodensystems gehören.

3. Optoelektronische Vorrichtung gemäß Anspruch 1, **dadurch gekennzeichnet, dass** die Sperrschicht (17) aus Indiumphosphid (InP) oder aus InGaAsP (Indium-Gallium-Arsen-Phosphor) oder aus InAlAs (Indium-Aluminium-Arsen) oder aus einer Kombination aus Materialien der Gruppe AllnGaAsP besteht.

4. Optoelektronische Vorrichtung gemäß Anspruch 1, **dadurch gekennzeichnet, dass** die aktive Zone (11) aus InGaAsP (Indium-Gallium-Arsen-Phosphor) oder aus einer Kombination aus Materialien der Gruppe AllnGaAsP besteht.

5. Optoelektronische Vorrichtung gemäß Anspruch 1, **dadurch gekennzeichnet, dass** die Breite der aktiven Zone (11) in etwa 1,5 Mikrometer und die Dicke der gemeinsamen Struktur einige Mikrometer beträgt.

6. Optoelektronische Vorrichtung gemäß Anspruch 1, **dadurch gekennzeichnet, dass** die Dicke der Sperrschicht weniger als einen Mikrometer beträgt.

7. Optoelektronische Vorrichtung gemäß Anspruch 1, **dadurch gekennzeichnet, dass** die Struktur eine Filterschicht umfasst, die zwischen dem Substrat und der aktiven Schicht angeordnet ist, wobei die genannte Schicht ebenfalls aus Indiumphosphor (InP) besteht.

8. Herstellungsverfahren für eine optoelektronische Vorrichtung vom Typ Laser mit integriertem Modulator gemäß einem der vorstehenden Ansprüche, das mindestens die folgenden Schritte umfasst:
• Schritt 1: Erzeugung der aktiven Zone (11) auf dem Substrat (10) mithilfe eines ersten epitaxischen Wachstums- und eines Ätzvorgangs;
• Schritt 2: Erzeugung der semi-isolierenden seitlichen Einschlussschicht (15) mithilfe eines zweiten epitaxischen Wachstumsvorgangs;
• Schritt 5: Erzeugung der semi-isolierenden vertikalen Einschlussschicht (16) mithilfe eines dritten epitaxischen Wachstumsvorgangs;
**dadurch gekennzeichnet, dass** das Herstellungsverfahren außerdem die beiden folgenden zusätzlichen Schritte umfasst, die zwischen dem zweiten Schritt und dem fünften Schritt ausgeführt werden;
• Schritt 3: Erzeugung der Sperrschicht (17) über die gesamte Fläche der semi-isolierenden seitlichen Einschlussschicht (15);
• Schritt 4: Beseitigung der Sperrschicht in dem Bereich der Struktur, der dem Modulationsabschnitt (2) entspricht.

9. Herstellungsverfahren gemäß Anspruch 8, **dadurch gekennzeichnet, dass** der Schritt 4 des Verfahrens mittels chemischer oder mechanischer Ätzung ausgeführt wird.
